(19) Europäisches Patentamt
European Patent Office
Office européen des brevets

(11) Veröffentlichungsnummer : **0 057 474**
**B1**

(12) # EUROPÄISCHE PATENTSCHRIFT

(45) Veröffentlichungstag der Patentschrift : **17.10.84**

(51) Int. Cl.$^3$ : **C 07 F 9/53**, C 07 F 9/32, C 07 F 9/58, C 07 F 9/65, C 08 F 2/50, C 08 K 5/53, G 03 C 1/68, G 03 F 1/02

(21) Anmeldenummer : **82102316.5**

(22) Anmeldetag : **09.07.79**

(60) Veröffentlichungsnummer der früheren Anmeldung nach Art. 76 EPÜ : **0007508**

(54) **Acylphosphinoxidverbindungen, ihre Herstellung und Verwendung.**

(30) Priorität : **14.03.79 DE 2909994**

(43) Veröffentlichungstag der Anmeldung : **11.08.82 Patentblatt 82/32**

(45) Bekanntmachung des Hinweises auf die Patenterteilung : **17.10.84 Patentblatt 84/42**

(84) Benannte Vertragsstaaten : **BE CH DE FR GB IT NL SE**

(56) Entgegenhaltungen :
**DE-A- 2 830 927**
**US-A- 3 668 093**
**US-A- 3 826 640**

(73) Patentinhaber : **BASF Aktiengesellschaft**
**Carl-Bosch-Strasse 38**
**D-6700 Ludwigshafen (DE)**

(72) Erfinder : **Lechtken, Peter, Dr.**
**Ludwigshafener Strasse 6B**
**D-6710 Frankenthal (DE)**
Erfinder : **Buethe, Ingolf, Dr.**
**Am Wasserturm 1**
**6737 Boehl-Iggelheim (DE)**
Erfinder : **Jacobi, Manfred, Dr.**
**Heidelberger Ring 32 B**
**D-6710 Frankenthal (DE)**
Erfinder : **Trimborn, Werner, Dr.**
**Hardenburgstrasse 22**
**D-6703 Limburgerhof (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 057 474 B1

**Beschreibung**

Die vorliegende Erfindung betrifft neue Acylphosphinoxid-Verbindungen, ihre Herstellung sowie ihre Verwendung als Photoinitiatoren in photopolymerisierbaren Überzugsmitteln, Lacken und Druckfarben.

Es sind bereits eine Reihe von Initiatoren für die Photopolymerisation ungesättigter Verbindungen bekannt. Bislang werden hauptsächlich aromatische Ketone wie Acetophenon- und Benzophenonderivate, Thioxanthone sowie Benzoinäther und Benzilketale eingesetzt. Mit derartigen Initiatoren ausgehärtete Massen zeigen jedoch eine unerwünschte Vergilbung, die eine Verwendung auf hellen (weißen) Flächen nicht zuläßt.

Ein weiterer Nachteil ist die oft ungenügende Lagerstabilität der fertig sensibilisierten Harzmischungen, die trotz Dunkellagerung häufig nur einige Tage haltbar sind.

So wird in US-A-3 668 093 die Verwendung von Aroylphosphinen als Photoinitiatoren beschrieben. Diese Verbindungen sind jedoch gegenüber Luft und Feuchtigkeit wenig stabil und führen zu unerwünscht starken Vergilbungen der damit gehärteten Harzmischungen.

Während in der US-A-3 826 640 der Einsatz von Benzoylphosphonaten als Herbizide beschrieben wird, war die Eignung dieser Stoffklasse als Photoinitiatoren bisher nicht bekannt.

In der DE-A-28 30 927 wurden bereits Acylphosphinoxid-Verbindungen als Photoinitiatoren vorgeschlagen. Aufgabe der vorliegenden Erfindung ist es, neue Acylphosphinoxid-Verbindungen aufzuzeigen, die die oben genannten Nachteile der bekannten Photoinitiatoren nicht aufweisen und auch gegenüber den in der DE-A-28 30 927 vorgeschlagenen Verbindungen Verbesserungen aufweisen.

Gegenstand der vorliegenden Erfindung sind Acylphosphinoxid-Verbindungen der allgemeinen Formel

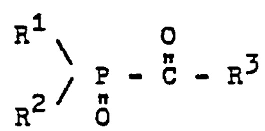

(I)

wobei

$R^1$ für einen geradkettigen oder verzweigten Alkylrest mit 1 bis 6 Kohlenstoffatomen, den Cyclohexyl-, den Cyclopentyl-, einen Aryl-, halogen-, alkyl, oder alkoxyl-substituierten Aryl-, einen S- oder N-haltigen fünf- oder sechsgliedrigen heterocyclischen Rest steht ;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ miteinander zu einem o-Phenylendioxyrest verbunden sind ;

$R^3$ für einen mindestens zweifach substituierten Phenyl-, Pyridyl-, Furyl- oder Thienyl-Rest steht, der mindestens an den beiden zur Verknüpfungsstelle mit der Carbonylgruppe benachbarten Kohlenstoffatomen die Substituenten A und B trägt, die untereinander gleich oder verschieden sein können, und für 1 bis 6 Kohlenstoffatome enthaltende Alkyl, Alkoxy- oder Alkylthioreste, 5 bis 7 Kohlenstoffatome enthaltende Cycloalkylreste, Phenylreste oder Halogen-, vorzugsweise Chlor- oder Brom-Atome stehen, oder $R^3$ für einen mindestens in den 2,8-Stellungen durch A und B substituierten $\alpha$-Naphthylrest oder mindestens in den 1,3-Stellungen durch A und B substituierten $\beta$-Naphthylrest steht.

Gegenstand der vorliegenden Erfindung ist außerdem ein Verfahren zur Herstellung der erfindungsgemäßen Acylphosphinoxid-Verbindungen sowie ihre Verwendung als Photoinitiatoren in photopolymerisierbaren Überzugsmitteln, Lacken und Druckfarben.

Bezüglich der allgemeinen Formel (I) der erfindungsgemäßen Acylphosphinoxid-Verbindungen ist im einzelnen folgendes auszuführen :

$R^1$ kann sein ein geradkettiger oder verzweigter Alkylrest mit 1 bis 6 C-Atomen wie Methyl-, Äthyl-, i-Propyl-, n-Propyl-, n-Butyl-, Amyl-, n-Hexyl-, Cyclopentyl-, Cyclohexyl-,

Aryl-, wie Phenyl-, Naphthyl-, halogensubstituiertes Aryl, wie Mono- oder Dichlorphenyl-,

alkylsubstituiertes Phenyl-, wie Methylphenyl-, Äthylphenyl-, Isopropylphenyl-, tert.-Butylphenyl-, Dimethylphenyl-,

alkoxysubstituiertes Aryl-, wie Methoxyphenyl-, Äthoxyphenyl-, Dimethoxyphenyl-,

S- oder N-haltige fünf- oder sechsgliedrige Ringe, wie Thienyl-, Pyridyl-.

Außer der Bedeutung von $R^1$ kann $R^2$ sein ein Alkoxyrest mit 1 bis 6 C-Atomen, wie Methoxy-, Äthoxy-, i-Propoxy-, Butoxy-, Äthoxyäthoxy-, ein Aryloxyrest, wie Phenoxy-, Methylphenoxy-, ein Arylalkoxyrest, wie Benzyloxy-.

$R^3$ kann ein 2,6-Dimethylphenyl-, 2,6-Dimethoxyphenyl-, 2,6-Dichlorphenyl-, 2,6-Dibromphenyl-, 2-Chlor-6-methoxyphenyl-, 2-Chlor-6-methylthio-phenyl-, 2,4,6-Trimethylphenyl-, 2,4,6-Trimethoxyphenyl-, 2,3,4,6-Tetramethylphenyl, 2,6-Dimethyl-4-tert.-butylphenyl-, 1,3-Dimethylnaphthalin-2-, 2,8-Dimethylnaphthalin-1-, 1,3-Dimethoxy-naphthalin-2-, 1,3-Dichlornaphthalin-2-, 2,8-Dimethoxynaphthalin-1-, 2,4,6-Trimethylpyridin-3-, 2,4-Dimethoxy-furan-3- oder ein 2,4,5-Trimethylthienyl-3-Rest sein.

Als Beispiele für die erfindungsgemäßen Photoinitiatoren seien genannt :

2,6-Dimethylbenzoyl-phenylphosphinsäuremethylester
2,6-Dimethoxybenzoyl-phenylphosphinsäuremethylester
2,6-Dimethylbenzoyl-diphenylphosphinoxid
2,6-Dimethoxybenzoyl-diphenylphosphinoxid
2,4,6-Trimethylbenzoyl-phenylphosphinsäuremethylester
2,4,6-Trimethylbenzoyl-diphenylphosphinoxid
2,3,6-Trimethylbenzoyl-diphenylphosphinoxid
2,4,6-Trimethylbenzoyl-tolylphosphinsäuremethylester
2,4,6-Trimethoxybenzoyl-diphenylphosphinoxid
2,6-Dichlorbenzoyl-phenylphosphinsäureäthylester
2,6-Dichlorbenzoyl-diphenylphosphinoxid
2-Chlor-6-methylthio-benzoyl-diphenylphosphinoxid
2,6-Dimethylthio-benzoyl-diphenylphosphinoxid
2,3,4,6-Tetramethylbenzoyldiphenylphosphinoxid
2-Phenyl-6-methylbenzoyl-diphenylphosphinoxid
2,6-Dibrombenzoyl-diphenylphosphinoxid
2,4,6-Trimethylbenzoyl-naphthylphosphinsäureäthylester
2,6-Dichlorbenzoyl-naphthylphosphinsäureäthylester
1,3-Dimethylnaphthalin-2-carbonyl-diphenylphosphinoxid
2,8-Dimethylnaphthalin-1-carbonyl-diphenylphosphinoxid
1,3-Dimethoxynaphthalin-2-carbonyl-diphenylphosphinoxid
1,3-Dichlornaphthalin-2-carbonyl-diphenylphosphinoxid
2,4,6-Trimethylpyridin-3-carbonyl-diphenylphosphinoxid
2,4-Dimethylfuran-3-carbonyl-diphenylphosphinoxid
2,4-Dimethoxyfuran-3-carbonyl-diphenylphosphinoxid
2,4,5-Trimethyl-thiophen-3-carbonyl-phenylphosphinsäuremethylester
2,4,5-Trimethyl-thiophen-3-carbonyl-diphenylphosphinoxid.

Besonders bevorzugt sind dabei Aroyl-phenylphosphinsäureester bzw. Aroyldiphenylphosphinoxide, deren Aroylrest jeweils in den o-Stellungen durch Alkyl-, Alkoxy-, Halogen-, Alkylthio-Reste oder Mischungen derselben substituiert ist, beispielsweise 2,6-Dimethylbenzoyldiphenylphosphinoxid, 2,4,6-Trimethylbenzoyldiphenylphosphinoxid, 2,4,6-Trimethylbenzoyl-phenyl-phosphinsäuremethylester, 2,6-Dichlorbenzoyl- oder 2,6-Dimethoxybenzoyldiphenylphosphinoxid.

Die Herstellung derartiger Verbindungen gelingt durch Umsetzung von Säurehalogeniden der Formel

$$R^3 - \overset{O}{\overset{\|}{C}} - X$$

X = Cl, Br
mit Phosphinen der Formel

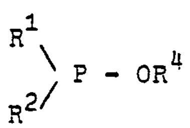

$R^4$ = geradkettiger oder verzweigter $C_1$- bis $C_6$-Alkyl, oder Cycloalkyl mit 5 oder 6 C-Atomen.

Die Umsetzung kann in einem Lösungsmittel, wie einem Kohlenwasserstoff oder Kohlenwasserstoffgemisch, wie Petroläther, Toluol, Cyclohexan, einem Äther, anderen üblichen inerten organischen Lösungsmitteln oder auch ohne Lösungsmittel bei Temperaturen zwischen − 30 und + 130 °C, bevorzugt bei 10 bis 100 °C, ausgeführt werden. Das Produkt kann aus dem Lösungsmittel direkt auskristallisiert werden, hinterbleibt nach dem Abdampfen oder wird im Vakuum destilliert.

Die Gewinnung der Säurehalogenide $R^3\overset{O}{\overset{\|}{C}}X$ und des substituierten Phosphins $R^1R^2POR^4$ erfolgt nach Verfahren, die dem Fachmann aus der Literatur bekannt sind (z. B. Weygand-Hilgetag, Organisch-Chemische Experimentierkunst, 4. Auflage, S. 246 bis 256, J. A. Barth-Verlag, Leipzig 1970 sowie K. Sasse in Houben-Weyl, Band 12/1, S. 208 bis 209, G. Thieme-Verlag, Stuttgart).

Das Verfahren zur Herstellung der erfindungsgemäßen Verbindungen läßt sich folgendermaßen beispielhaft beschreiben :

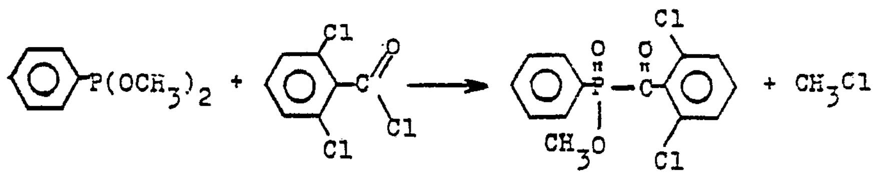

bzw.

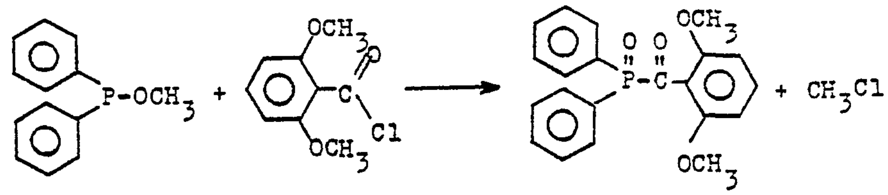

Geeignete Phosphine sind z. B. Methyl-dimethoxyphosphin, Butyldimethoxyphosphin, Phenyldimethoxyphosphin, Tolyldimethoxyphosphin, Phenyldiäthoxyphosphin, Tolyldiäthoxyphosphin, Phenyldiisopropoxyphosphin, Tolyldiisopropoxyphosphin, Phenyldibutoxyphosphin, Tolyldibutoxyphosphin bzw. Dimethylmethoxyphosphin, Dibutylmethoxyphosphin, Dimethylbutoxyphosphin, Diphenylmethoxyphosphin, Diphenyläthoxyphosphin, Diphenylpropoxyphosphin und Diphenylbutoxyphosphin.

Als Säurehalogenide eignen sich Chloride und Bromide, besonders bevorzugt sind jedoch Säurechloride.

Die Verbindungen der erfindungsgemäßen Struktur zeigen eine sehr gute Reaktivität als Photoinitiatoren für photopolymerisierbare Monomere mit mindestens einer C-C-Mehrfachbindung und Mischungen derselben miteinander und mit bekannten Zusatzstoffen. Insbesondere die bevorzugten o-disubstituierten Aroyl-diphenylphosphinoxide bzw. Aroyl-phenylphosphinsäureester besitzen darin eine ausgezeichnete Lagerstabilität bei sehr hoher Reaktivität. Dies gilt vor allem für die zumeist verwendeten Harze auf Basis der styrolhaltigen ungesättigten Polyester sowie für die styrolfreien Acrylsäureester. Mit den erfindungsgemäßen Initiatoren lassen sich zudem weiß pigmentierte Lacke vergilbungsfrei aushärten, aber auch bunt pigmentierte Harze verarbeiten. In diesen Eigenschaften übertreffen sie die bekannten Photoinitiatoren wie z. B. Benzildimethylketal oder α-Hydroxyisobutyrophenon.

Weiterhin wurde überraschend gefunden, daß diese Vorteile erhalten bleiben oder sogar noch verstärkt werden, wenn man die bevorzugten Aroyldiphenylphosphinoxide mit bekannten Photoinitiatoren kombiniert anwendet.

Besonders wirksame synergistische Mischungen ergeben sich bei Kombinationen mit bekannten Photoinitiatoren auf Basis der aromatischen Ketone, insbesondere Benzildimethylketal, α-Hydroxyisobutyrophenon, Diäthoxyacetophenon, Benzophenon und 2-Methylthioxanthon, 2-Isopropylthioxanthon sowie 2-Chlor-thioxanthon. Dabei nutzt man durch Zugabe tert. Amine wie Methyldiäthanolamin noch deren bekannte beschleunigende Wirkung aus. Durch Kombination der erfindungsgemäßen Initiatoren mit z. B. Benzildimethylketal gelingt es überraschend wirksame, sehr lagerstabile, aminfreie, photopolymerisierbare Massen herzustellen, die ggf. auch pigmentiert sein können.

Als photopolymerisierbare Monomere eignen sich die üblichen Verbindungen und Stoffe mit polymerisierbaren C-C-Doppelbindungen, die durch z. B. Aryl-, Carbonyl-, Amino-, Amid-, Amido-, Ester-, Carboxy- oder Cyanid-Gruppen, Halogenatome oder C-C-Doppel- oder C-C-Dreifachbindungen aktiviert sind. Genannt seien beispielsweise Vinyläther und Vinylester, Styrol, Vinyltoluol, Acrylsäure und Methacrylsäure sowie deren Ester mit ein- und mehrwertigen Alkoholen, deren Nitrile oder Amide, Malein- und Fumarester sowie N-Vinylpyrrolidon, N-Vinylcaprolactam, N-Vinylcarbazol und Allylester wie Diallylphthalat.

Als polymerisierbare höhermolekulare Verbindungen sind beispielsweise geeignet: ungesättigte Polyester, hergestellt aus α,β-ungesättigten Dicarbonsäuren wie Maleinsäure, Fumarsäure oder Itaconsäure, ggf. im Gemisch mit gesättigten bzw. aromatischen Dicarbonsäuren wie Adipinsäure, Phthalsäure, Tetrahydrophthalsäure oder Terephthalsäure, durch Umsetzung mit Alkandiolen wie Äthylenglykol, Propylenglykol, Butandiol, Neopentylglykol oder oxalkyliertem Bisphenol-A; Epoxidacrylate, hergestellt aus Acryl- oder Methacrylsäure und aromatischen oder aliphatischen Diglycidyläthern, Polyesteracrylate (z. B. hergestellt aus hydroxylgruppenhaltigen gesättigten Polyestern und Acryl- oder Methacrylsäure) und Urethanacrylate.

Gegebenenfalls können die photopolymerisierbaren Überzugsmittel, Lacke und Druckfarben auch als wäßrige Dispersionen vorliegen oder zur Anwendung gebracht werden.

Den photopolymerisierbaren Verbindungen, deren Zusammensetzung für den jeweiligen Verwendungszweck dem Fachmann geläufig ist, können in bekannter Weise gesättigte und/oder ungesättigte Polymere sowie weitere Zusatzstoffe wie Inhibitoren gegen die thermische Polymerisation, Paraffin, Pigmente, Farbstoffe, Peroxide, Verlaufshilfsmittel, Füllstoffe und Mattierungsmittel sowie Stabilisatoren gegen thermischen oder photochemischen Abbau zugesetzt sein.

Solche Gemische sind dem Fachmann bekannt und Art und Menge der Zusätze hängen vom jeweiligen Verwendungszweck ab.

Die erfindungsgemäßen Verbindungen werden dabei im allgemeinen in einer Konzentration von 0,001 bis 20 %, vorzugsweise von 0,1 bis 5 % bezogen auf die photopolymerisierbare Masse eingesetzt. Sie können ggf. mit Beschleunigern kombiniert werden, die den hemmenden Einfluß des Luftsauerstoffs auf die Photopolymerisation beseitigen.

Solche Beschleuniger bzw. Synergisten sind beispielsweise sekundäre und/oder tert. Amine wie Methyldiäthanolamin, Dimethyläthanolamin, Triäthylamin, Triäthanolamin, p-Dimethylaminobenzoesäureäthylester, Benzyl-dimethylamin, Dimethylaminoäthylacrylat, N-Phenylglycin, N-Methyl-N-Phenylglycin und analoge, dem Fachmann bekannte Verbindungen. Zur Beschleunigung der Aushärtung können weiterhin aliphatische und aromatische Halogenide dienen wie 2-Chlormethylnaphthalin, 1-Chlor-2-chlormethyl-naphthalin sowie Radikalbildner wie Peroxide und Azo-Verbindungen.

Als Strahlungsquellen für das die Polymerisation solcher Mischungen auslösende Licht verwendet man solche, die Licht vorzugsweise im Absorptionsbereich der erfindungsgemäßen Verbindungen aussenden, d. h. zwischen 230 und 450 nm. Besonders geeignet sind Quecksilber-Niederdruckstrahler-, Mitteldruck- und Hochdruckstrahler sowie Leuchtstoffröhren oder Impulsstrahler. Die genannten Lampen können ggf. dotiert sein.

Die in den nachstehenden Beispielen genannten Teile und Prozente beziehen sich, soweit nicht anders angegeben auf das Gewicht. Volumenteile verhalten sich zu Teilen wie Liter zu Kilogramm.

## Beispiel 1

Zu einer Mischung aus 1 350 Volumenteilen Petroläther (Siedebereich 40 bis 70 °C), 180 Volumenteilen N,N-Diäthylanilin und 67 Volumenteilen Methanol werden unter Rühren bei 0 °C 225 Teile Diphenylchlorphosphin, gelöst in 220 Volumenteilen Petroläther, zugegeben. Danach rührt man die Mischung noch 2 Stunden bei Raumtemperatur. Nach Abkühlung auf ca. + 5 °C saugt man das ausgeschiedene Aminhydrochlorid ab und destilliert das Filtrat zunächst bei 1 300 bis 2 500 Pa, um alles Leichtsiedende zu entfernen. Sodann wird das Diphenylmethoxyphosphin bei 13 bis 130 Pa fraktioniert destilliert. Sdp. (67 Pa) : 120 bis 124 °C. Ausbeute : 175 Teile (80 % bezogen auf Diphenylchlorphosphin).

In einer Rührapparatur mit Rückflußkühler und Tropftrichter werden bei 50 bis 55 °C 648 Teile Methoxydiphenylphosphin zugegeben. Man rührt noch 4 bis 5 Stunden bei 50 °C nach, löst den Kolbeninhalt bei 30 °C in Äther und versetzt bis zur beginnenden Trübung mit Petroläther. Beim Abkühlen kristallisieren 910 Teile (87 % d. Th.) 2,4,6-Trimethylbenzoyl-diphenylphosphinoxid. Fp. : 80 bis 31 °C, schwach gelbe Kristalle.

## Beispiel 2

In einer Apparatur nach Beispiel 1 werden 20 Teile 2,6-Dimethoxybenzoylchlorid in 20 Volumenteilen Toluol suspendiert und zu dieser Mischung bei 50 bis 55 °C unter Rühren 21,6 Teile Methoxydiphenylphosphin zugetropft. Man rührt noch 3 Stunden bei 50 °C nach und kristallisiert dann direkt aus Toluol um. Man erhält 32 Teile gelbliche Kristalle, Fp. : 124 bis 126 °C.

## Beispiel 3

In einer Apparatur nach Beispiel 1 werden 91 Teile 2,4,6-Trimethylbenzoylchlorid vorgelegt. Dazu gibt man bei 60 °C innerhalb von 15 Min. 83 Teile Triäthylphosphit und rührt dann bei 80 °C noch 8 Stunden nach. Der Kolbenaustrag wird bei vermindertem Druck von 52 Pa destilliert und die Fraktion bei 120 bis 122 °C/52 Pa aufgefangen. Man erhält 51 Teile 2,4,6-Trimethylbenzoyl-phosphonsäurediäthylester (36 Prozent d. Th.) als schwach gelbliche Flüssigkeit.

## Beispiel 4

Zu einer Mischung aus 1 000 Volumenteilen Toluol, 421 Volumenteilen N,N-Diäthylanilin und 100 Volumenteilen Methanol werden bei 0 °C 214 Teile Phenyldichlorphosphin zugegeben. Danach rührt man noch 1 Stunde bei Raumtemperatur, saugt den Niederschlag von Aminhydrochlorid ab und fraktioniert. Das Dimethoxyphenylphosphin destilliert bei 46 bis 50 °C/26 bis 39 Pa. Ausbeute : 190 Teile (93 % d. Th.).

Zu 182,5 Teilen 2,4,6-Trimethylbenzoylchlorid werden bei 50 °C 170 Teile Dimethoxyphenylphosphin zugetropft. Man hält noch 5 Stunden bei 50 °C, löst das schwach gelbliche Öl bei 70 bis 80 °C in Cyclohexan und bringt das Produkt dann durch Abkühlen auf 5 °C zur Kristallisation. Man erhält schwach gelbliche Kristalle, Fp. : 51 bis 52 °C, Ausbeute : 81 % d. Th.

Weitere Verbindungen, die analog zu Beispiel 1 bis 4 hergestellt wurden, enthält Tabelle 1.

(Siehe Tabelle 1 Seite 6 f.)

Tabelle 1 : Acylphosphinoxid-Derivate

| | Ausbeute | Sdp. (mm) | Fp °C | | Analyse C | H | P |
|---|---|---|---|---|---|---|---|
| 2,4,6-Trimethylbenzoyl-diphenylphosphinoxid | | | | ber. | 75,86 | 6,03 | 8,91 |
| | 87 % | — | 80-81 | gef. | 75,9 | 6,1 | 8,9 |
| 2,4,6-Trimethylbenzoyl-phenylphosphinsäuremethylester | | | | ber. | 67,55 | 6,29 | 10,26 |
| | 81 % | — | 51-52 | gef. | 67,5 | 6,5 | 10,1 |
| 2,6-Dichlorbenzoyl-diphenylphosphinoxid | | | | ber. | 60,8 | 3,47 | 8,27 |
| | 82 % | — | 154-159 | gef. | 60,9 | 3,7 | 8,1 |
| 2,6-Dimethoxybenzoyl-diphenylphosphinoxid | | | | ber. | 68,86 | 5,19 | 8,47 |
| | 88 % | — | 124-126 | gef. | 68,7 | 5,4 | 8,2 |
| 2,3,5,6-Tetramethylbenzoyl-diphenylphosphinoxid | | | | ber. | 76,24 | 6,36 | 8,56 |
| | 63 % | — | 123-125 | gef. | 76,2 | 6,5 | 8,4 |
| Vergleichssubstanzen : | | | | | | | |
| 2,4,6-Trimethylbenzoyl-phosphonsäurediäthylester | | 120-122 | | ber. | 59,15 | 7,39 | 10,92 |
| | 36 % | (52 Pa) | — | gef. | 59,3 | 7,6 | 10,7 |
| 2,4-Dichlorbenzoyl-diphenylphosphinoxid | | | | ber. | 60,8 | 3,47 | 8,27 |
| | 76 % | — | 116-117 | gef. | 60,9 | 3,6 | 8,3 |
| 3,4-Dimethylbenzoyldiphenylphosphinoxid | | | | ber. | 75,45 | 5,69 | 9,28 |
| | 90 % | — | 72-74 | gef. | 75,2 | 5,7 | 8,9 |

Beispiel 5

In einem Bindemittel aus 65 Teilen eines Umsetzungsproduktes aus Bisphenol-A-diglyzidäthers und Acrylsäure, 35 Teilen Butan-1,4-dioldiacrylat und 3 Teilen Methyldiäthanolamin werden 3 Teile Photoinitiator gelöst. Die fertige Mischung wird auf Glasplatten in einer Schicht von 60 μ Dicke aufgebracht und in 10 cm Abstand unter einer Quecksilberhochdrucklampe (Leistung 80 W/cm Bodenlänge) vorbeigeführt. Die Reaktivität ist als die maximal mögliche Transportbandgeschwingdigkeit angegeben, bei der noch eine kratzfeste Aushärtung des Lackfilms erzielt wird.

Tabelle 2 : Reaktivität der Photoinitiatoren

| Photoinitiatior | Reaktivität (Transportgeschwindigkeit) m/min |
|---|---|
| 2,6-Dichlorbenzoyldiphenylphosphinoxid | 30 |
| 2,4,6-Trimethylbenzoyldiphenylphosphinoxid | 70 |
| 2,6-Dimethoxybenzoyldiphenylphosphinoxid | 70 |
| Vergleichssubstanzen : | |
| 2,4-Dichlorbenzoyldiphenylphosphinoxid | < 10 |
| 3,4-Dimethylbenzoyldiphenylphosphinoxid | < 10 |
| Benzildimethylketal | 60 |

2,6-substituierte Derivate zeigen also eine wesentlich höhere Reaktivität als Derivate, die Substituenten in anderen Stellungen des Benzoylrests tragen.

Beispiel 6

Ein Lacksystem analog Beispiel 5 wird mit folgenden Photoinitiatorkombinationen versetzt und wie bei Beispiel 5 geprüft.

(Siehe Tabelle Seite 7 f.)

| Photoinitiatorsystem | Reaktivität (m/min) | Pendelhärte nach König (sec) bei 12m/min |
|---|---|---|
| 3 Teile Bensophenon | 12 | 97 |
| 2 Teile Benzophenon | | |
| 1 Teil 2,4,6-Trimethylbenzoldiphenylphosphinoxid | 75 | 213 |
| 3 Teile 2,4,6-Trimethylbenzoyldiphenylphosphinoxid | 70 | 188 |
| 2 Teile Benzophenon | | |
| 1 Teil 2,6-Dimethoxybenzoyldiphenylphosphinoxid | 75 | 210 |
| 3 Teile 2,6-Dimethoxybenzoyldiphenylphosphinoxid | 70 | 183 |

Beispiel 7

In einer Mischung aus 55 Teilen eines Umsetzungsproduktes von Bisphenol-A-diglycidäther und Acrylsäure, 45 Teilen Butandioldiacrylat, 55 Teilen Rutil-Pigment und 3 Teilen Methyldiäthanolamin werden die folgenden Photoinitiatoren gelöst. Die fertige Mischung wird mit einer Spirale (80 µm) auf Glasplatten aufgezogen und unter zwei hintereinander angeordneten Hg-Hochdrucklampen (Leistung je 80 W/m) vorbeigeführt. Die Transportbandgeschwindigkeit, bei der noch eine kratzfeste Aushärtung möglich ist, kennzeichnet die Reaktivität des Initiatorsystems.

In einem zweiten Ansatz wird obige Zusammensetzung in einer Schichtdicke von 200 µ aufgerakelt. Nach der UV-Härtung wird die Schicht abgelöst, mit Aceton gewaschen und anschließend die ausgehärtete Schichtdicke bestimmt. Man erhält so ein Maß für die Durchhärtung.

| Photoinitiator | Reaktivität (m/min) | Weißgrad nach Berger (% Rem.) | durchgehärtete Schichtdicke |
|---|---|---|---|
| 2 Teile 2-Methylthioxanthon | 12 | 66 | 130 µ |
| 1,5 Teile 2-Methylthioxanthon<br>0,5 Teile 2,4,6-Trimethylbenzoyldiphenylphosphinoxid | 20 | 76 | 140 µ |
| 1,0 Teile 2-Methylthioxanthon<br>1,0 Teile 2,4,6-Trimethylbenzoyldiphenylphosphinoxid | 20 | 78 | 140 µ |
| 2 Teile 2,4,6-Trimethylbenzoylphosphinoxid | 6 | 81 | 70 µ |

Beispiel 8

In einer Mischung aus 55 Teilen eines Umsetzungsproduktes von Bisphenol-A-diglycidäther und Acrylsäure, 45 Teilen Butandiol-diacrylat und 55 Teilen Rutil-Pigment werden die zu vergleichenden Photoinitiatoren gelöst. Man zieht den fertigen Lack in einer Dicke von 80 µm auf Glasplatten auf und härtet wie in Beispiel 7 beschrieben. Man findet, daß Benzildimethylketal oder α-Hydroxyisobutyrophenon allein keine Aushärtung des pigmentierten Lackes bewirken. Ohne wesentliche Einbußen an Aushärtung können sie jedoch einen Teil des erfindungsgemäßen Initiators 2,4,6-Trimethylbenzoyldiphenylphosphinoxid ersetzen.

| Initiator | Konzentration | Pendelhärte in sec. bei einer Transportbandgeschwindigkeit von 6 m/min | 12 m/min |
|---|---|---|---|
| 2,4,6-Trimethylbenzoyldiphenylphosphinoxid | 3 % | 81 | 56 |
| 2,4,6-Trimethylbenzoyldiphenylphosphinoxid<br>α-Hydroxyisobutyrophenon | 2 %<br>1 % | 78 | 43 |
| 2,4,6-Trimethylbenzoyldiphenylphosphinoxid<br>Benzildimethylketal | 2 %<br>1 % | 71 | 61 |
| α-Hydroxyisobutyrophenon<br>Benzildimethylketal | 3 %<br>3 % | jeweils nur oberflächlich trocken | |

Beispiel 9

Durch Veresterung von 431 Teilen Maleinsäureanhydrid und 325 Teilen Phthalsäureanhydrid mit 525 Teilen Propylenglykol-1,2 wird ein ungesättigter Polyester hergestellt. Nach Zugabe von 0,01 % Hydrochinon wird von dem Polyester eine 66 %ige Lösung in Styrol hergestellt und darin der jeweilige Photoinitiator gelöst.

Für die Lichthärtungsversuche werden zu 100 Teilen dieser Mischung 10 Teile einer 1 %igen Lösung von Paraffin (Erweichungsbereich 50 bis 52 °C) in Styrol zugesetzt und das Harz auf Glasplatten mit einem Filmaufziehgerät der Spalttiefe 400 μ aufgetragen. Nach etwa einminütigem Ablüften werden die Filme mit Leuchtstofflampen (Philips TLA05/40 W), die im Abstand von 4 cm angebracht sind, belichtet. Diese Prüfung wurde nach einer Dunkel-Lagerzeit des photopolymerisierbaren Gemisches von 5 Tagen bei 60 °C wiederholt. Nach einer Belichtungszeit von jeweils 2 Minuten erhält man folgende Ergebnisse :

| Photoinitiator | Konzentration | Pendelhärte nach König (sec) sofort | Pendelhärte nach König (sec) nach 5 Tg. bei 60 °C |
|---|---|---|---|
| 2,4,6-Trimethylbenzoyldiphenylphosphinoxid | 1 % | 73 | 73 |
| 2,6-Dimethoxybenzoyldiphenylphosphinoxid | 2 % | 62 | 60 |
| Pivaloyldiphenylphosphinoxid (Vergleich) | 2 % | 60 | 10 |
| Benzildimethylketal (Vergleich) | 2 % | 45 | 40 |
| α-Hydroxyisobutyrophenon (Vergleich) | 2 % | 20 | 19 |

Beispiel 10

Durch Veresterung von 143 Teilen Tetrahydrophthalsäureanhydrid und 175 Teile Maleinsäureanhydrid mit 260 Teilen Diäthylenglykol wird ein ungesättigtes Polyesterharz hergestellt, das 64 %ig in Styrol gelöst und mit 0,01 % Hydrochinon stabilisiert wird.

Für Lichthärtungsversuche werden zu 100 Teilen dieser Lösung 20 Teile $TiO_2$, 10 Teile einer 1 %igen Paraffinlösung in Styrol sowie der jeweilige Initiator in der angegebenen Menge zugesetzt. Das Harz wird mit einem Rakel in einer Schichtdicke von 60 μ auf Glasplatten aufgezogen und sofort 20 Sekunden unter einer Hg-Hochdrucklampe (100 W/cm Bodenlänge) im Abstand von 10 cm bestrahlt. Man erhält folgende Ergebnisse :

| | Konzentration des Initiators | Pendelhärte nach König (sec) |
|---|---|---|
| 2,4,6-Trimethylbenzoyldiphenylphosphinoxid | 1 % | 126 |
| 2,6-Dimethoxybenzoyldiphenylphosphinoxid | 1 % | 81 |
| 3,4-Dimethylbenzoyldiphenylphosphinoxid | 2 % | 20 |
| Benzil, Methyldiäthanolamin | 2 % + 4 % | 32 |

Während die mit den erfindungsgemäßen Initiatoren sensibilisierten Harze nach Lagerung von 5 Tagen bei 60 °C keinen nennenswerten Reaktivitätsabfall zeigten, war der Ansatz mit Benzil/Amin bereits geliert.

Beispiel 11

Zu 100 Teilen eines nach Beispiel 10 hergestellten Harzes gibt man 15 Teile einer 0,7 %igen Lösung von Paraffin (Schmpkt. 50 bis 52 °C) in Styrol, in der man gleichzeitig den Photoinitiator gelöst hat. Man setzt dem Harz noch 3 % Buntpigment zu, rakelt 100 μ dicke Filme auf Glas auf und belichtet 20 sec wie in Beispiel 10. Man ersieht aus diesen Ergebnissen, daß die erfindungsgemäßen Initiatoren auch zum Härten buntpigmentierter Lacke bzw. von Druckfarben geeignet sind, auch wenn sie mit hierzu nicht oder nur wenig brauchbaren herkömmlichen Initiatoren kombiniert werden, d. h. sie zeigen einen synergistischen Effekt.

| Initiator | Pendelhärte nach König in sec. bei Pigmentierung durch | | |
|---|---|---|---|
| | Heliogen-grün 8721 | Heliogen-blau 7080 | Lithol-scharlach 4300 |
| 2 Teile 2,4,6-Trimethylbenzoyldiphenylphosphinoxid | 123 | 129 | 161 |
| 1 Teil 2,4,6-Trimethylbenzoyldiphenylphosphinoxid<br>1 Teil Benzildimethylketal | 129 | 125 | 170 |
| 2 Teile Benzildimethylketal | 49 | nur oberflächlich gehärtet | 169 |

**Ansprüche**

1. Acylphosphinoxid-Verbindungen der allgemeinen Formel

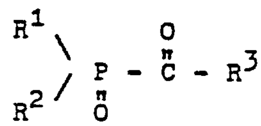

(I)

wobei

$R^1$ für einen geradkettigen oder verzweigten Alkylrest mit 1 bis 6 Kohlenstoffatomen, den Cyclohexyl-, den Cyclopentyl-, einen Aryl-, halogen-, alkyl- oder alkoxyl-substituierten Aryl-, einen S- oder N-haltigen fünf- oder sechsgliedrigen heterocyclischen Rest steht ;

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ miteinander zu einem o-Phenylendioxyrest verbunden sind ;

$R^3$ für einen mindestens zweifach substituierten Phenyl-, Pyridyl-, Furyl- oder Thienyl-Rest steht, der mindestens an den beiden zur Verknüpfungsstelle mit der Carbonylgruppe benachbarten Kohlenstoffatomen die Substituenten A und B trägt, die untereinander gleich oder verschieder sein können, und für 1 bis 6 Kohlenstoffatome enthaltende Alkyl-, Alkoxy- oder Alkylthioreste, 5 bis 7 Kohlenstoffatome enthaltende Cycloalkylreste, Phenylreste oder Halogenatome stehen, oder für einen mindestens in den 2,8-Stellungen durch A und B substituierten α-Naphtylrest oder mindestens in den 1,3-Stellungen durch A und B substituierten β-Naphthylrest steht.

2. Acylphosphinoxid-Verbindungen nach Anspruch 1, dadurch gekennzeichnet, daß $R^3$ ein 2,4,6-Trimethylphenyl-, 2,3,6-Trimethylphenyl-, 2,6-Dimethoxyphenyl-, 2,6-Dichlorphenyl-, 2,6-Di-(methylthio)-phenyl- oder ein 2,3,5,6-Tetramethylphenylrest ist.

3. Acylphosphinoxid-Verbindungen nach Anspruch 1, dadurch gekennzeichnet, daß $R^3$ ein 2,4,5-Trimethylpyridyl-3- oder ein 2,4-Dimethylthiophenyl-3-Rest ist.

4. Acylphosphinoxid-Verbindungen nach Anspruch 1, dadurch gekennzeichnet, daß $R^3$ ein 1,3-Dimethyl-naphthalin-2-, ein 2,6-Dimethylnaphthalin-1-, ein 1,3-Dimethoxy-naphthalin-2- oder ein 2,8-Dimethoxynaphthalin-1-Rest ist.

5. Acylphosphinoxid-Verbindungen nach Anspruch 1 bis 4, dadurch gekennzeichnet, daß $R^1$ und $R^2$ die Bedeutung Phenyl oder $C_1$ bis $C_6$-Alkyl-substituiertes Phenyl haben.

6. Verfahren zur Herstellung der Acylphosphinverbindungen nach Anspruch 1 bis 5, dadurch gekennzeichnet, daß man Säurehalogenide der allgemeinen Formel

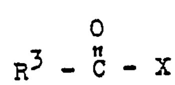

worin X für Chlor oder Brom steht und $R^3$ die oben genannte Bedeutung hat, mit einem Phosphin der allgemeinen Formel

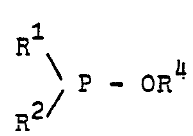

worin $R^1$ und $R^2$ die oben genannte Bedeutung haben und $R^4$ für einen geradkettigen oder verzweigten 1

bis 6 Kohlenstoffatome enthaltenden Alkylrest oder einen Cycloalkylrest mit 5 oder 6 Kohlenstoffatomen stehen, bei Temperaturen zwischen − 30 und + 130 °C ggf. in Gegenwart eines inerten organischen Lösungsmittels umsetzt.

7. Verwendung von Acylphosphinoxid-Verbindungen nach Anspruch 1 bis 5 als Photoinitiatoren in photopolymerisierbaren Überzugsmitteln, Lacken und Druckfarben in einer Konzentration von 0,001 % bis 20 %, vorzugsweise von 0,01 % bis 4 %.

8. Verwendung von Acylphosphinoxid-Verbindungen nach Anspruch 1 bis 5 als Photoinitiatoren in photopolymerisierbaren Überzugsmitteln, Lacken und Druckfarben in Kombination mit sekundären oder tertiären Aminen.

9. Verwendung von Acylphosphinoxid-Verbindungen nach Anspruch 1 bis 5 als Photoinitiatoren in Kombination mit aromatischen Ketonen, in einem Mischungsverhältnis Acylphosphinoxid-Verbindung : aromatisches Keton von 10 : 1 bis 1 : 30, vorzugsweise 1 : 1 bis : 10 in Überzugsmitteln, Lacken und Druckfarben.

10. Verwendung nach Anspruch 9, dadurch gekennzeichnet, daß als Beschleuniger ein tert. Amin in einer Konzentration von 0,5 bis 15 % zugesetzt wird.

11. Verwendung von Acylphosphinoxid-Verbindungen des Anspruchs 1 bis 5 in Kombination mit einem tert. Amin sowie mit Benzophenon und bzw. oder Thioxanthon, die ggf. noch Methyl-, Isopropyl-, Chlor- oder Chlormethylreste tragen können, oder mit Benzildimethylketal, Benzoinisopropyläther, α-Hydroxyisobutyrophenon, Diäthoxyacetophenon oder p.-tert.-Butyltrichloracetophenon mit der Maßgabe, daß der Gesamtgehalt an Photoinitiatorsystem zwischen 1 % und 20 % der Gesamtmenge des photopolymerisierbaren Gemisches liegt.

## Claims

1. An acylphosphine oxide compound of the general formula

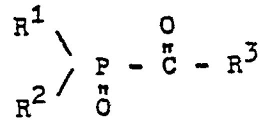

(I)

where

$R^1$ is straight-chain or branched alkyl of 1 to 6 carbon atoms, cyclohexyl, cyclopentyl, aryl which is unsubstituted or substituted by halogen, alkyl or alkoxy, or an S-containing or N-containing five-membered or six-membered heterocyclic radical,

$R^2$ has the same meanings as $R^1$, $R^1$ and $R^2$ being identical or different, or is alkoxy of 1 to 6 carbon atoms, aryloxy or aralkoxy, or $R^1$ and $R^2$ are connected together to form an o-phenylenedioxy radical, and

$R^3$ is an at least disubstituted phenyl, pyridyl, furyl or thienyl radical which bears, at least at the two carbon atoms adjacent to the linkage point of the carbonyl group, the substitutents A and B, which may be identical or different, and each of which is alkyl, alkoxy or alkylthio of 1 to 6 carbon atoms, cycloalkyl of 5 to 7 carbon atoms, phenyl or halogen, or $R^3$ is α-naphthyl substituted by A and B at least in the 2- and 8-positions or is β-naphthyl substituted by A and B at least in the 1- and 3-positions.

2. An acylphosphine compound as claimed in claim 1, wherein $R^3$ is 2,4,6-trimethylphenyl, 2,3,6-trimethylphenyl, 2,6-dimethoxyphenyl, 2,6-dichlorophenyl, 2,6-di-(methylthio)-phenyl or 2,3,5,6-tetramethylphenyl.

3. An acylphosphine oxide compound as claimed in claim 1, wherein $R^3$ is 2,4,6-trimethylpyrid-3-yl or 2,4-dimethylthien-3-yl.

4. An acylphosphine oxide compound as claimed in claim 1, wherein $R^3$ is 1,3-dimethylnaphthalen-2-yl, 2,8-dimethylnaphthalen-1-yl, 1,3-dimethoxynaphthalen-2-yl or 2,8-dimethoxynaphthalen-1-yl.

5. An acylphosphine oxide compound as claimed in claims 1 to 4, wherein $R^1$ and $R^2$ are phenyl or $C_1$-$C_6$-alkyl-substituted phenyl.

6. A process for the preparation of an acylphosphine compound as claimed in claims 1 to 5, wherein an acid halide of the general formula

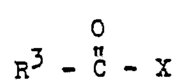

where X is chlorine or bromine and $R^3$ has the above meaning, is reacted with a phosphine of the general formula

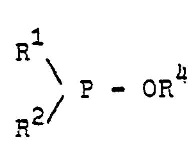

where $R^1$ and $R^2$ have the above meanings and $R^4$ is straightchain or branched alkyl of 1 to 6 carbon atoms or is cycloalkyl of 5 or 6 carbon atoms, at from − 30 to + 130 °C, in the presence or absence of an inert organic solvent.

7. Use of an acylphosphine oxide compound as claimed in claims 1 to 5 as a photoinitiator in photopolymerizable coating materials, paints and printing inks, the compound being used in a concentration of from 0.001 % to 20 %, preferably from 0.01 % to 4 %.

8. Use of an acylphosphine oxide compound as claimed in claim 1 as a photoinitiator in photopolymerizable coating materials, paints and printing inks, in combination with secondary or tertiary amines.

9. Use of an acylphosphine oxide compound as claimed in claim 1 as a photoinitiator in coating materials, paints and printing inks in combination with an aromatic ketone, in a ratio of acylphosphine oxide compound to aromatic ketone of from 10 : 1 to 1 : 30, preferably from 1 : 1 to 1 : 10.

10. Use as claimed in claim 9, wherein the accelerator is a tertiary amine, added in a concentration of from 0.5 to 15 %.

11. Use of an acylphosphine oxide compound as claimed in claims 1 to 5 in combination with a tertiary amine and with benzophenone and/or thioxanthone, either of which may or may not be substituted by methyl, isopropyl, chlorine or chloromethyl, or with benzil dimethylketal, benzoin isopropyl ether, α-hydroxyisobutyrophenone, diethoxyacetophenone or p-tert.-butyltrichloroacetophenone, with the proviso that the total content of photoinitiator system is from 1 % to 20 % of the total amount of the photopolymerizable mixture.

**Revendications**

1. Dérivés d'oxydes d'acyl-phosphines de la formule générale

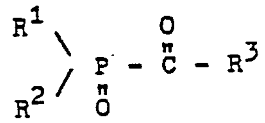

(I)

dans laquelle

$R^1$ désigne un radical alcoyle à chaîne droite en ramifiée en $C_1$ à $C_6$, un groupe cyclohexyle ou cyclopentyle, un groupe aryle éventuellement halo-, alcoyl- ou alcoxy-substitué ou un groupe hétérocyclique penta- ou hexa-gonal contenant du soufre ou de l'azote ;

$R^2$ a la même signification que $R^1$, $R^1$ et $R^2$ pouvant être identiques ou différents, ou désigne un radical alcoxy en $C_1$ à $C_6$ ou un groupe aryloxy ou arylalcoxy, ou forme avec $R^1$ un groupe o-phénylène-dioxy, et

$R^3$ représente un groupe phényle, pyridyle, furyle ou thiényle au moins disubstitué, portant au moins sur les deux atomes de carbone adjacents à la liaison au groupe carbonyle des substituants A et B, qui peuvent être identiques ou différents et sont choisis parmi les radicaux alcoyle, alcoxy et alcoylthio en $C_1$ à $C_6$, les groupes cycloalcoyle en $C_5$ à $C_7$ ou phényle et les atomes d'halogène, ou un groupe α-naphtyle substitué au moins sur les positions 2 et 8 par des substituants A et B ou un groupe β-naphtyle portant au moins sur les positions 1 et 3 des substituants A et B.

2. Dérivés d'oxydes d'acyl-phosphines suivant la revendication 1, caractérisés en ce que $R^3$ est choisi parmi les groupes triméthyl-2,4,6 phényle, triméthyl-2,3,6 phényle, diméthoxy-2,6 phényle, dichloro-2,6 phényle, di-méthyl-thio-2,6 phényle et tétraméthyl-2,3,5,6 phényle.

3. Dérivés d'oxydes d'acyl-phosphines suivant la revendication 1, caractérisés en ce que $R^3$ désigne un groupe triméthyl-2,4,6 pyridyle-3 ou un groupe diméthyl-2,4 thiényle-3.

4. Dérivés d'oxydes d'acyl-phosphines suivant la revendication 1, caractérisés en ce que $R^3$ est choisi parmi les groupes diméthyl-1,3 naphtalène-2, diméthyl-2,8 naphtalène-1, diméthoxy-1,3 naphtalène-2 et diméthoxy-2,8 naphtalène-1.

5. Dérivés d'oxydes d'acyl-phosphines suivant les revendications 1 à 4, caractérisés en ce que $R^1$ et $R^2$ désignent chacun un groupe phényle ou un groupe phényle substitué par un radical alcoyle en $C_1$ à $C_6$.

6. Procédé de préparation de dérivés d'acyl-phosphines suivant l'une des revendications 1 à 5, caractérisé en ce que l'on fait réagir un halogénure d'acide de la formule générale

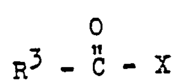

dans laquelle X représente un atome de chlore ou de brome et $R^3$ possède la signification définie plus haut, à des températures comprises entre − 30 et + 130 °C, éventuellement en présence d'un solvant organique inerte, avec une phosphine de la formule générale

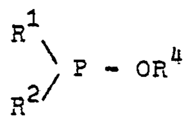

dans laquelle $R^1$ et $R^2$ possèdent la signification définie et $R^4$ représente un radical alcoyle à chaîne droite ou ramifiée en $C_1$ à $C_6$ ou un groupe cycloalcoyle en $C_5$ ou $C_6$.

7. Utilisation de dérivés d'oxydes d'acyl-phosphines suivant les revendications 1 à 5 comme photo-initiateurs dans des encres d'impression, des vernis et des produits d'enduction photopolymérisables en une proportion de 0,01 à 20 % et de préférence de 0,01 à 4 %.

8. Utilisation de dérivés d'oxydes d'acyl-phosphines suivant les revendications 1 à 5 comme photo-initiateurs dans des encres d'impression, des vernis et des produits d'enduction photopolymérisables en combinaison avec des amines secondaires ou tertiaires.

9. Utilisation des dérivés d'oxydes d'acyl-phosphines suivant les revendications 1 à 5 en combinaison avec des cétones aromatiques comme photo-initiateurs dans des produits d'enduction, des vernis et des encres d'impression, le rapport de mélange de l'oxyde d'acyl-phosphine à la cétone aromatique étant compris entre 10 : 1 et 1 : 30 et de préférence entre 1 : 1 et 1 : 10.

10. Utilisation suivant la revendication 9, caractérisé en ce que l'on incorpore en tant qu'accélérateur une amine tertiaire en une concentration de 0,5 à 15 %.

11. Utilisation de dérivés d'oxydes d'acyl-phosphines suivant les revendications 1 à 5 en combinaison avec une amine tertiaire, ainsi qu'avec de la benzophénone et (ou) de la thioxanthone éventuellement méthyl-, isopropyl-, chloro- ou chloro-méthyl-substituées, ou avec du diméthylcétal de benzile, de l'éther isopropylique de benzoïne, de l'α-hydroxy-isobutyro-phénone, de la diéthoxy-acétophénone ou de la p-tert.-butyl-trichloracéto-phénone, la concentration totale en système photo-initiateur se situant entre 1 et 20 % de la quantité totale du mélange photopolymérisable.